# DEMANDE DE BREVET EUROPEEN

(11) **EP 1 227 331 A2**
(43) Date de publication de la demande: **31.07.2002**
(21) Numéro de dépôt: 02360042.2
(22) Date de dépôt: 23.01.2002
(51) Int. Cl.: G01R 33/36

(54) **Circuit d'excitation et de récupération du signal émis par une sonde dans un appareil de spectrométrie RMN**

(30) Priorité: 24.01.2001 FR 0100942
(71) Demandeur: Bruker Biospin SA, 67160 Wissembourg (FR)
(72) Inventeur: Martinache, Laurent, 67500 Marienthal (FR); Tyburn, Jean-Max, 67160 Wissembourg (FR); Gonella, Olivier, 67240 Bischwiller (FR); Brevard, Christian, 67160 Wissembourg (FR)
(74) Mandataire: Nuss, Pierre

(57) **Abrégé**

La présente invention concerne un circuit d'excitation d'une sonde de mesure et de récupération du signal émis en retour par cette dernière dans un appareil de spectrométrie RMN, reliant ladite sonde (1) dans, des conditions définies par des moyens de commutation (2, 2') faisant partie dudit circuit, à un générateur (3) de signaux d'excitation hautes-fréquences par une portion de ligne ou ligne d'émission (4), et par une portion de ligne ou ligne de réception (6), à un récepteur (5) pour l'acquisition et l'exploitation des signaux émis par ladite sonde en fonction de l'échantillon à analyser qu'elle contient, un dispositif étant, en outre, prévu pour réaliser ou vérifier l'accord de la sonde de mesure avec le générateur de signaux d'excitation, associé ou intégré audit circuit.

Circuit caractérisé en ce que ledit dispositif comprend un coupleur directif (7), monté en série dans ou en parallèle sur la portion de ligne d'émission (4).

## Description

La présente invention concerne le domaine des appareils d'analyse RMN, notamment l'accord fréquentiel des sondes de mesure de ces appareils aux conditions de l'analyse à réaliser, et a pour objet un dispositif ou un montage de circuits pour l'accord en fréquence d'une sonde RMN.

Les appareils de spectrométrie RMN (résonance magnétique nucléaire) se composent principalement d'un générateur de signaux hautes-fréquences, d'une sonde de mesure placée dans le champ d'un aimant de hautes homogénéité et stabilité, et d'un récepteur.

Le principe de mise en oeuvre d'une mesure RMN consiste à exciter l'échantillon placé dans la sonde de mesure par une impulsion hautes-fréquences, puis à enregistrer la réponse en fréquences. L'information spectrale contenue dans celle-ci permet une analyse de la structure moléculaire de l'échantillon.

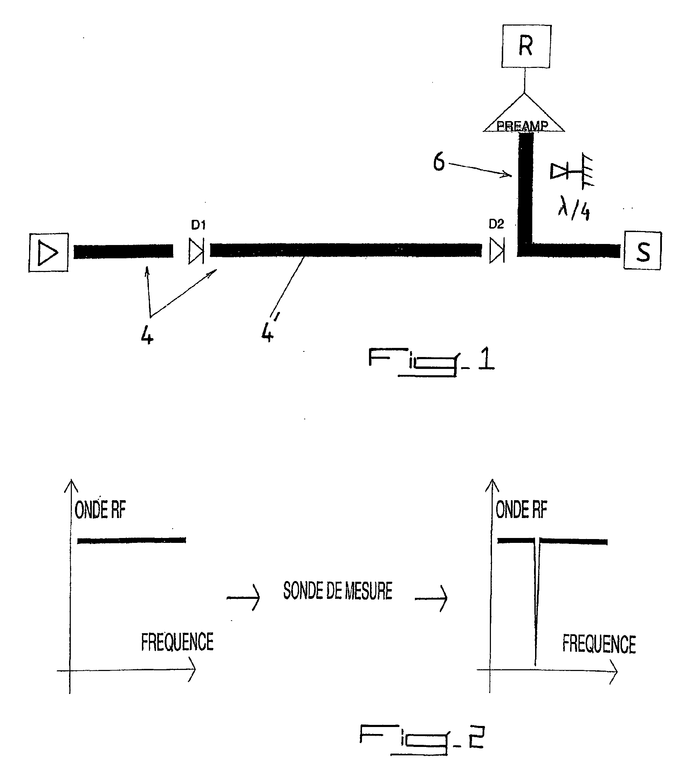

Une structure traditionnelle d'un circuit d'excitation d'une telle sonde S et du signal émis en retour par cette dernière et récupéré par un récepteur R adapté, normalement précédé par un préamplificateur (PREAMP), est représenté schématiquement sur la figure 1 des dessins annexés.

Avant toute mesure l'utilisateur doit préalablement s'assurer que la sonde de mesure est bien accordée à la fréquence de travail utilisée pour effectuer la mesure. Cela signifie que l'onde hautes-fréquences doit être absorbée par la sonde sans réflexion d'énergie.

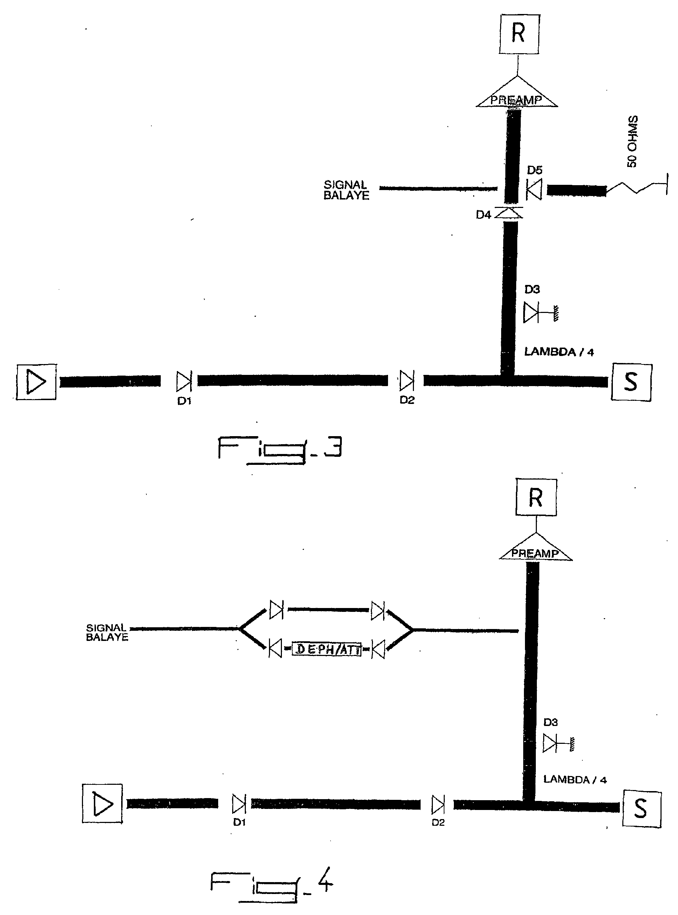

A cet effet, les spectromètres modernes sont pourvus d'un dispositif de balayage qui permet de visualiser la proportion d'énergie réfléchie par la sonde en fonction de la fréquence, cette mesure préalable ou plutôt sa représentation graphique est généralement dénommée image de mode de la sonde de mesure (voir figure 2 des dessins annexés).

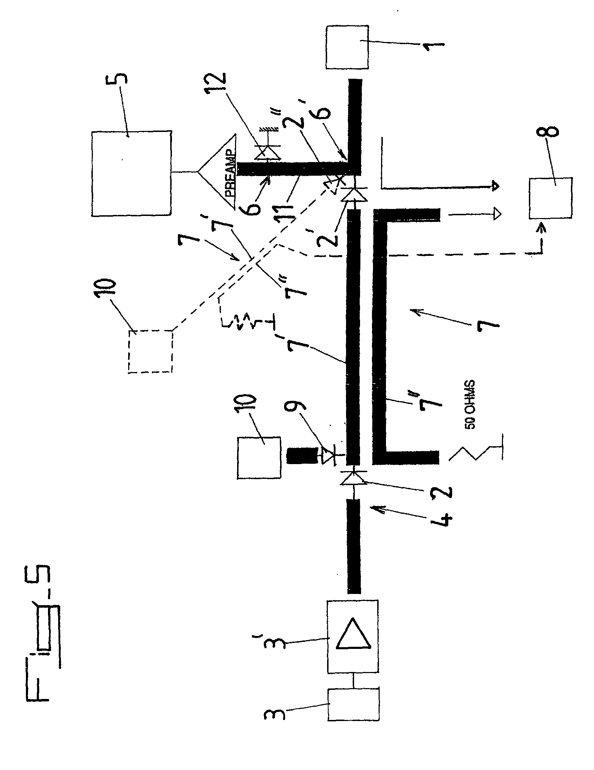

Un montage couramment utilisé actuellement pour vérifier l'accord de la sonde de mesure est représenté à la figure 3. Il comprend un élément de commutation hautes-fréquences (en général une diode PIN référencée sur la figure 3 par D4) insérée entre la sonde S et le récepteur R, afin de présenter à ce dernier soit l'image de l'énergie réfléchie par la sonde, soit une charge adaptée (50 OHMS) ne présentant pas de réflexion. Par soustraction vectorielle des deux images (image de la sonde et image de référence), on déduit le profil de réflexion réel de la sonde sous test.

Cette opération de traitement mathématique nécessaire présente plusieurs inconvénients. En effet, le rayonnement balayé en fréquence est injecté vers la sonde mais aussi vers le récepteur, ce qui provoque un phénomène d'ondes stationnaires qu'il convient de corriger par la mesure de la charge adaptée de référence (50 OHMS). Ce montage présente aussi l'inconvénient de nécessiter la présence d'un élément de commutation en amont du récepteur qui nuit à sa sensibilité.

Par ailleurs, il est également connu de mettre en oeuvre une ligne de référence, de manière à pouvoir réaliser une correction de l'image de la sonde par une image de référence.

Un montage mettant en oeuvre cette solution est notamment décrit et représenté dans le document US-A-5 552 710 (voir figure 4 des dessins annexés) et permet, par rapport au montage précité traditionnellement utilisé, de s'affranchir de tout élément de commutation supplémentaire.

La mise en oeuvre du montage de ce document consiste à diriger l'onde hautes-fréquences dans deux voies distinctes suivants que l'on enregistre l'image de la sonde S ou l'image de référence.

Pendant l'acquisition de l'image de référence, une des diodes de commutation existantes D3 est passante. Le signal balayé passe par la voie de référence, se réfléchit sur D3 et alimente le préamplificateur (PREAMP) précédant le récepteur R.

La voie de référence est normalement calibrée en usine en termes d'amplitude et de phase afin que le signal reçu par le récepteur R soit identique à celui qu'il aurait reçu si la sonde de mesure avait été remplacée par une charge adaptée.

Cette image de référence est en quelque sorte l'image idéale dont il convient de se rapprocher. Par l'autre voie, on mesure l'image de la sonde comme dans le montage traditionnel précité et l'image finale est obtenue par soustraction vectorielle des deux images.

L'inconvénient de ce dernier montage est qu'il nécessite une circuiterie complexe, résultant en un montage d'ensemble compliqué, pour assurer un bon équilibrage des deux voies en amplitude et en phase. Ce montage est également très limité en termes de bandes passante.

La présente invention a notamment pour but de pallier les inconvénients des dispositifs et montages connus précités et de proposer un montage permettant un accord aisé des sondes dans les spectromètres, garantissant un maintien de la sensibilité du récepteur, sans ajout de composant de commutation entre la sonde et le récepteur et présentant une structure simple.

A cet effet, la présente invention a pour objet un circuit d'excitation d'une sonde de mesure et de récupération du signal émis en retour par cette dernière dans un appareil de spectrométrie RMN, reliant ladite sonde dans, des conditions définies par des moyens de commutation faisant partie dudit circuit, à un générateur de signaux d'excitation hautes-fréquences par une portion de ligne ou ligne d'émission, et par une portion de ligne ou ligne de réception, à un récepteur pour l'acquisition et l'exploitation des signaux émis par ladite sonde en fonction de l'échantillon à analyser qu'elle contient, un dispositif étant, en outre, prévu pour réaliser ou vérifier l'accord de la sonde de mesure avec le générateur de signaux d'excitation, associé ou intégré audit circuit, circuit caractérisé en ce que ledit dispositif comprend un coupleur directif, monté en série dans ou en parallèle sur la portion de ligne d'émission.

L'invention sera mieux comprise, grâce à la description ci-après, qui se rapporte à un mode de réalisation préféré, donné à titre d'exemple non limitatif, et expliqué avec référence aux dessins schématiques annexés, dans lesquels la figure 5 est une représentation schématique fonctionnelle du dispositif selon l'invention.

Comme le montre la figure 5 des dessins annexés, le circuit d'excitation d'une sonde de mesure 1 et de récupération du signal émis en retour par cette dernière dans un appareil de spectrométrie RMN (non représenté), relie ladite sonde, dans des conditions définies par des moyens de commutation faisant partie dudit circuit, à un générateur 3 de signaux d'excitation hautes-fréquences par une portion de ligne ou ligne d'émission 4 et, par une portion de ligne ou ligne de réception 6, à un récepteur 5 pour l'acquisition et l'exploitation des signaux émis par ladite sonde 1 en fonction de l'échantillon à analyser qu'elle contient, un dispositif étant, en outre, prévu pour réaliser ou vérifier l'accord de la sonde de mesure 1 avec le générateur de signaux d'excitation, le dispositif étant associé ou intégré audit circuit.

Conformément à l'invention, ce circuit est caractérisé en ce que ledit dispositif comprend un coupleur directif 7, monté en série dans ou en parallèle sur la portion de ligne d'émission 4.

Le coupleur directif 7 permet de séparer l'onde émise vers la sonde 1 et incidente au niveau de cette dernière, de l'onde réfléchie en retour par ladite sonde de mesure 1.

Ainsi, lors de l'émission du signal balayé en phase d'accord de 1a sonde, ledit coupleur directif 7, relié à un générateur adéquat 10, permet de produire une vraie image de la réflexion d'énergie produite par la sonde de mesure 1 en fonction de la fréquence, sans nécessiter de composant de commutation supplémentaire en série entre la sonde de mesure 1 et le récepteur 5 et tout en conservant une structure très simple, non sujette à des ajustements délicats à obtenir et à préserver.

Le coupleur directif 7 présentera avantageusement une directivité (couplage + isolation), sur une large bande, au moins égale à 30dB et pourra par exemple être du type connu sous la désignation 10013-30 par la société ANAREN, sa ligne secondaire étant équilibrée par une charge adaptée (50 Ohms).

Selon une première variante de réalisation, dont les caractéristiques particulières sont représentées en traits interrompus ou pointillés sur la figure 5, le coupleur directif 7 est monté en parallèle sur la ligne d'émission 4 et relié, de manière contrôlée, à cette dernière par sa ligne principale au moyen d'un élément de commutation 2", ladite ligne principale 7' étant alimentée, pour la vérification de l'accord, par un signal balayé et la ligne secondaire 7" dudit coupleur 7 étant alors reliée, au niveau de sa borne opposée à la borne de la ligne principale alimentée par le signal balayé, à un moyen 8 d'acquisition et de visualisation de la réponse spectrale correspondant à l'onde réfléchie par la sonde de mesure 1, préférentiellement le moyen d'acquisition et de visualisation de l'appareil de spectrométrie.

Selon une seconde variante de réalisation préférée de l'invention, représentée en traits continus sur la figure 5 (suppression des détails en pointillés), le coupleur directif 7 est monté en série dans la ligne d'émission 4. Dans ce cas, la ligne principale 7' dudit coupleur directif 7 forme une partie de ladite ligne d'émission 4 et elle est reliée directement par des moyens de commutation 2, 9 adaptés, au générateur 3 de signaux d'excitation ou au générateur 10 de signal balayé, la ligne secondaire 7" étant ou pouvant être reliée, au niveau de sa borne opposée à la borne de la ligne principale 7' alimentée par le signal issu du générateur 3 de signaux d'excitation, à un moyen 8 d'acquisition et de visualisation de l'onde réfléchie par la sonde de mesure 1, préférentiellement le moyen d'acquisition et de visualisation de l'appareil de spectrométrie.

Afin de rapprocher le plus possible les conditions de mesure dans la phase de vérification de celles prévalant dans la phase de mise en oeuvre effective de l'appareil de spectrométrie, c'est-à-dire lors de l'analyse d'échantillons excités par les signaux émis par le générateur 3, le coupleur directif 7 est avantageusement monté à proximité, et préférentiellement le plus prés possible, de la sortie du générateur 3 de signaux d'excitation ou d'un module ou composant d'amplification 3' lui faisant suite.

Conformément au mode de réalisation préféré de l'invention, représenté sur la figure 5 et s'appréciant en relation avec la figure 1, il est prévu que la ligne d'émission 4 comporte des moyens de commutation sous la forme de deux diodes 2 et 2' montées en série et que le coupleur directif 7 soit monté de telle manière que sa ligne principale 7' forme au moins une partie (préférentiellement la totalité) du segment de ligne d'émission 4' s'étendant entre les deux diodes 2 et 2'.

En réalisant pendant la phase de prise de référence (accord de la sonde) un blocage de la diode 2', il est possible de visualiser et d'acquérir, au niveau du moyen 8, les éventuelles imperfections résultant du générateur 10 et de la chaîne de transmission reliant 10 à 8 (et incluant notamment le coupleur directif 7).

Cette mesure peut s'avérer très intéressante lorsque les fréquences de travail sont comprises entre quelques MHz et quelques centaines de MHz.

En effet, elle favorise notamment l'automatisation de l'accord de 1a sonde, car la courbe affichée au niveau du moyen 8 sera l'image vraie de la sonde, c'est-à-dire corrigée des imperfections dues à la chaîne de transmission comprenant notamment le coupleur 7, lesdites imperfections acquises préalablement étant prises en compte lors de l'affichage et de l'acquisition de l'image de la sonde pour les déduire du signal recueilli.

Ainsi, il sera possible d'accélérer le processus d'accord de la sonde et de l'effectuer, par exemple, avant chaque séquence de mesure, en garantissant une prise en compte des éventuelles évolutions des imperfections précitées.

En vue d'éviter toute pollution du récepteur pendant la phase d'émission, il y a lieu d'isoler le préamplificateur précédant le récepteur 5.

A cet effet, la ligne de réception 6 comporte, immédiatement en aval de son point de connexion 6' avec la ligne d'émission 4, un segment de ligne de réception pouvant être transformée de manière contrôlée en tronçon de ligne 11 quart d'onde ou lambda/4 (λ/4), par exemple par court circuitage à la terre (mise à la terre) par une diode 12 commandée aux instants appropriés, en relation avec les autres moyens de communication.

La présente invention concerne également un appareil de spectrométrie RMN, caractérisé en ce qu'il comporte un circuit d'excitation et de récupération du signal de mesure tel que décrit ci-dessus.

Enfin, l'invention concerne aussi un procédé de vérification de l'accord entre une sonde de mesure RMN et un générateur de signaux d'excitation ou un composant d'amplification desdits signaux avant leur transmission par une ligne d'émission vers ladite sonde, dans un appareil de spectrométrie RMN du type précité, caractérisé en ce qu'il consiste à alimenter la ligne principale 7' du coupleur directif 7 par un signal balayé, puis à relever, à visualiser et à analyser 1a réponse spectrale correspondant au signal réfléchi par la sonde de mesure 1 au niveau de la borne de la ligne secondaire 7" opposée à la borne de la ligne principale 7' reliée au générateur de signal balayé 10.

On notera que l'acquisition de l'image de mode de la sonde est réalisée directement et en temps réel, sans aucune correction ou autre opération mathématique supplémentaire.

Lorsque le coupleur directif présente éventuellement des imperfections, le procédé de vérification peut, en variante à ce qui précède, consister à établir, préalablement à la phase de vérification de l'accord proprement dite, la réponse ou l'image spectrale de la fonction de transfert du coupleur directif 7, puis à alimenter la ligne principale 7' dudit coupleur 7 par un signal balayé, à recueillir et à acquérir la réponse spectrale correspondant au signal réfléchi par la sonde de mesure 1 au niveau de la borne de la ligne secondaire 7" opposée à la borne de la ligne secondaire 7" reliée au générateur de signal balayé 10, à soustraire ensuite la réponse spectrale de la fonction de transfert précitée de la réponse spectrale correspondant au signal réfléchi de la sonde 1 et, enfin, à visualiser et à analyser l'image spectrale résultante.

Dans le cas du mode de réalisation du circuit représenté schématiquement sur la figure 5, la combinaison des diodes 2 et 2' (diodes de commutation émission réflexion) et du coupleur directif 7 permet ainsi de s'affranchir d'éventuelles imperfections du coupleur (par exemple dans le cas d'un fonctionnement large bande). Il suffit en effet d'alimenter 1e coupleur 7 avec le générateur 3 et d'ouvrir le circuit en 2', l'énergie réfléchie mesurée est alors l'image de la fonction de transfert du coupleur 7. Par soustraction, l'image de mode de la sonde de mesure 1 pourra ainsi d'être présentée corrigée des imperfections dudit coupleur 7.

Bien entendu, l'invention n'est pas limitée au mode de réalisation décrit et représenté aux dessins annexés. Des modifications restent possibles, notamment du point de vue de la constitution des divers éléments ou par substitution d'équivalents techniques, sans sortir pour autant du domaine de protection de l'invention.

## Revendications

1. Circuit d'excitation d'une sonde de mesure et de récupération du signal émis en retour par cette dernière dans un appareil de spectrométrie RMN, reliant ladite sonde, dans des conditions définies par des moyens de commutation faisant partie dudit circuit, à un générateur de signaux d'excitation hautes-fréquences par une portion de ligne ou ligne d'émission et, par une portion de ligne ou ligne de réception, à un récepteur pour l'acquisition et l'exploitation des signaux émis par ladite sonde en fonction de l'échantillon à analyser qu'elle contient, un dispositif étant, en outre, prévu pour réaliser ou vérifier l'accord de la sonde de mesure avec le générateur de signaux d'excitation, associé ou intégré audit circuit, circuit **caractérisé en ce que** ledit dispositif comprend un coupleur directif (7), monté en série dans ou en parallèle sur la portion de ligne d'émission (4).

2. Circuit selon la revendication 1, **caractérisé en ce que** le coupleur directif (7) est monté en parallèle sur la ligne d'émission (4) et relié, de manière contrôlée, à cette dernière par sa ligne principale au moyen d'un élément de commutation (2"), ladite ligne principale (7') étant alimentée, pour la vérification de l'accord, par un signal balayé et la ligne secondaire (7") dudit coupleur (7) étant reliée, au niveau de sa borne opposée à la borne de la ligne principale alimentée par le signal balayé, à un moyen (8) d'acquisition et de visualisation de la réponse spectrale correspondant à l'onde réfléchie par la sonde de mesure (1), préférentiellement le moyen d'acquisition et de visualisation de l'appareil de spectrométrie.

3. Circuit selon la revendication 1, **caractérisé en ce que** le coupleur directif (7) est monté en série dans la ligne d'émission (4), **en ce que** la ligne principale (7') dudit coupleur directif (7) forme une partie de ladite ligne d'émission (4) et **en ce qu'**elle est reliée directement par des moyens de commutation (2, 9) adaptés, au générateur (3) de signaux d'excitation ou au générateur (10) de signal balayé, la ligne secondaire (7") étant ou pouvant être reliée, au niveau de sa borne opposée à la borne de la ligne principale (7') alimentée par le signal issu du générateur (3) de signaux d'excitation, à un moyen (8) d'acquisition et de visualisation de l'onde réfléchie par la sonde de mesure (1), préférentiellement le moyen d'acquisition et de visualisation de l'appareil de spectrométrie.

4. Circuit selon la revendication 3, **caractérisé en ce que** le coupleur directif (7) est monté à proximité de la sortie du générateur (3) de signaux d'excitation ou d'un module ou composant d'amplification (3') lui faisant suite.

5. Circuit selon l'une quelconque des revendications 3 et 4, **caractérisé en ce que** lorsque la ligne d'émission (4) comporte des moyens de commutation sous la forme de deux diodes (2 et 2') montées en série, le coupleur directif (7) est monté de telle manière que sa ligne principale (7') forme au moins une partie du segment de ligne d'émission (4') s'étendant entre les deux diodes (2 et 2').

6. Circuit selon l'une quelconque des revendications 1 à 5, **caractérisé en ce que** la ligne de réception (6) comporte, immédiatement en aval de son point de connexion (6') avec la ligne d'émission (4), un segment de ligne de réception pouvant être transformée de manière contrôlée en tronçon de ligne (11) quart d'onde ou lambda/4.

7. Appareil de spectrométrie RMN, **caractérisé en ce qu'**il comporte un circuit selon l'une quelconque des revendications 1 à 6.

8. Procédé de vérification de l'accord entre une sonde de mesure RMN et un générateur de signaux d'excitation ou un composant d'amplification desdits signaux avant leur transmission par une ligne d'émission vers ladite sonde, dans un appareil de spectrométrie RMN selon la revendication 7, **caractérisé en ce qu'**il consiste à alimenter la ligne principale (7') du coupleur directif (7) par un signal balayé, puis à relever, à visualiser et à analyser la réponse spectrale correspondant au signal réfléchi par la sonde de mesure (1) au niveau de la borne de la ligne secondaire (7") opposée à la borne de la ligne principale (7') reliée au générateur de signal balayé (10).

9. Procédé de vérification de l'accord entre une sonde de mesure RMN et un générateur de signaux d'excitation ou un composant d'amplification desdits signaux avant leur transmission par une ligne d'émission vers ladite sonde, dans un appareil de spectrométrie RMN selon la revendication 7, **caractérisé en ce qu'**il consiste à établir, préalablement, la réponse ou l'image spectrale de la fonction de transfert du coupleur directif (7), puis à alimenter la ligne principale (7') dudit coupleur (7) par un signal balayé, à recueillir et à acquérir la réponse spectrale correspondant au signal réfléchi par la sonde de mesure (1) au niveau de la borne de la ligne secondaire (7") opposée à la borne de la ligne secondaire (7") reliée au générateur de signal balayé (10), à soustraire ensuite la réponse spectrale de la fonction de transfert précitée de la réponse spectrale correspondant au signal réfléchi de la sonde (1) et, enfin, à visualiser et à analyser l'image spectrale résultante.
